(19) Europäisches Patentamt / European Patent Office / Office européen des brevets

(11) **EP 3 905 152 B1**

(12) **EUROPÄISCHE PATENTSCHRIFT**

(45) Veröffentlichungstag und Bekanntmachung des Hinweises auf die Patenterteilung:
**27.11.2024  Patentblatt 2024/48**

(21) Anmeldenummer: **21171010.8**

(22) Anmeldetag: **28.04.2021**

(51) Internationale Patentklassifikation (IPC):
**G06Q 10/04** *(2023.01)*    **G06Q 50/08** *(2012.01)*

(52) Gemeinsame Patentklassifikation (CPC):
**G06Q 10/04; G06Q 50/08**

(54) **VERFAHREN UND VORRICHTUNG ZUM AUSLEGEN EINER FENSTERKONSTRUKTION**

METHOD AND DEVICE FOR DESIGNING A WINDOW STRUCTURE

PROCÉDÉ ET DISPOSITIF DE DÉPLOIEMENT D'UNE CONSTRUCTION DE FENÊTRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.04.2020  DE 102020111572**

(43) Veröffentlichungstag der Anmeldung:
**03.11.2021  Patentblatt 2021/44**

(60) Teilanmeldung:
**24207594.3**

(73) Patentinhaber: **Salamander Industrie-Produkte GmbH**
**86842 Türkheim (DE)**

(72) Erfinder: **Schmiedeknecht, Till**
**80992 München (DE)**

(74) Vertreter: **Schmid, Nils T.F.**
**SKM-IP PartGmbB**
**Oberanger 45**
**80331 München (DE)**

(56) Entgegenhaltungen:
WO-A1-2019/230997    US-A1- 2014 278 697
US-A1- 2019 180 140    US-B1- 7 340 407

**Beschreibung**

Die Erfindung betrifft ein Verfahren zum Auslegen einer Fensterkonstruktion an einem Bauprojekt. Bei dem Bauprojekt kann es sich um einen Altbau handeln, der bereits mit einer Fensterkonstruktion versehen ist, oder um einen Neubau, bei dem die Fensterkonstruktion noch nicht existent oder unvollständig sein kann.

Das Auslegen einer Fensterkonstruktion erfolgt typischerweise bei einer Begutachtung des Bauprojekts z.B. durch einen Architekten oder einen auf Fenster spezialisierten Zwischenhändler. Dieses Vorgehen zum Auslegen der Fensterkonstruktion ist zeitaufwändig, da der Architekt oder Zwischenhändler zusammen mit dem Bauherrn vor Ort sein muss und alle Fenster der Fensterkonstruktion einzeln erfasst und ausgelegt werden müssen. Zudem hat sich herausgestellt, dass in der Praxis oft keine optimale Auslegung erfolgt, insbesondere wenn die Auslegung nicht durch speziell geschultes Fachpersonal durchgeführt wird.

Im Zusammenhang mit dem Bestreben, einen Energieverbrauch maximal zu optimieren und gleichzeitig hohen Wohnkomfort zu garantieren, stellen sich übliche Verfahren oft als unzureichend heraus.

US 2014/0214473 A1 beschreibt ein Verfahren und ein System zum Bereitstellen eines Verkaufs- und Marketingwerkzeugs, bei dem mit einem mobilen Endgerät, wie einem Smartphone, Informationen bezüglich eines Bauwerks und darin vorgesehener Bauelemente erfasst, nachvollzogen und abgerufen werden können. Allerdings hat sich herausgestellt, dass mit dem in US 2014/0214473 A1 beschriebenen Verkaufs- und Marketingwerkzeug noch nicht eine optimale Auslegung von Fensterkonstruktionen an Bauprojekten vorgenommen werden kann.

US 2019/180140 A1 offenbart Systeme und Verfahren zum Ranking von Einheiten unter Verwendung von Baustellenbildern. Beispielsweise können mit mindestens einem Bildsensor von einer Baustelle aufgenommene Bilddaten gewonnen werden. Die Bilddaten können analysiert werden, um mindestens ein Element zu detektieren, das in den Bilddaten abgebildet und einer Entität zugeordnet ist. Die Bilddaten können weiter analysiert werden, um mindestens eine Eigenschaft zu bestimmen, die auf Qualität hinweist und dem mindestens ein Element zugeordnet ist. Die mindestens eine Eigenschaft kann verwendet werden, um ein Ranking der Entität zu erzeugen. In einigen Beispielen kann die mindestens eine Eigenschaft auf einer Diskrepanz zwischen einem Bauplan und der Baustelle, zwischen einem Projektzeitplan und der Baustelle, zwischen einer Finanzaufzeichnung und der Baustelle, zwischen einer Fortschrittsaufzeichnung und der Baustelle basieren, und so weiter.

Es ist eine Aufgabe der Erfindung, die Nachteile des Stands Technik zu überwinden und insbesondere ein alternatives Verfahren und eine Vorrichtung bereitzustellen mit dem einfach, präzise und verlässlich eine Auslegung einer Fensterkonstruktion an einem Bauprojekt durchgeführt werden kann.

Diese Aufgabe lösen die Gegenstände der unabhängigen Ansprüche. Demnach ist Computer-implementiertes Verfahren zum Auslegen einer Fensterkonstruktion an einem Bauprojekt bereitgestellt, das umfasst:

- Erfassen einer Himmelsrichtung zumindest einer Gebäudeseite des Bauprojekts,
- Erfassen von Fensterflächen der Fensterkonstruktion zugeordnet zu Gebäudeseiten des Bauprojekts, und
- Berechnen von Auslegungsparametern der Fensterkonstruktion basierend auf den erfassten Daten und einer Datenbank von Fenstern, wobei die Berechnung der Auslegungsparameter umfasst, eine Lichtsituation des Bauprojekts zu optimieren, und
- Erfassen eines Geräuschpegels im Innen- und/oder Außenraum des Bauprojekts, unter Verwendung eines Mikrophons der mobilen Vorrichtung, wobei das Berechnen der Auslegungsparameter umfasst, eine Geräuschsituation des Bauprojekts zu optimieren.

Dieses Verfahren wird vorzugsweise mit einer mobilen Vorrichtung, z.B. einem Smartphone oder einem Tablet-Computer durchgeführt. Das Erfassen der Himmelsrichtung kann durch einen Kompass erfolgen, z.B. indem ein Benutzer mit der mobilen Vorrichtung vor einer Gebäudeseite steht und die Kompass-Ausrichtung zugeordnet zur Gebäudeseite gespeichert wird.

Es versteht sich, dass Himmelsrichtung hierin nicht nur als Norden, Osten, Süden, Westen umfasst, sondern sich auch auf einen Wert dazwischen, z.B. auf eine Winkelausrichtung 10° östlich von der Nordausrichtung beziehen kann.

In anderen Ausführungsformen kann vorgesehen sein, dass das Erfassen der Himmelsrichtung nicht oder zumindest nicht nur über einen Kompass der mobilen Vorrichtung erfolgt: Stattdessen kann eine geographische Koordinate anhand eines Satellitennavigationssystems (z.B. GPS oder Galileo) bestimmt werden. Weiterhin kann anhand eines Kartenservices (z.B. Google Maps) erkannt werden, dass sich die bestimmte geographische Koordinate z.B. unmittelbar vor der nach Norden ausgerichteten Seite eines Gebäudes befindet. Somit kann die Himmelsrichtung einer Gebäudeseite aus dem im Kartenservice hinterlegten Grundriss des Gebäudes bestimmt werden.

Das Berechnen der Auslegungsparameter basierend auf erfassten Daten und Datenbank kann umfassen, ein oder mehrere Fenster aus der Datenbank zu bestimmen, mit denen eine Zielgröße, z.B. die Lichtsituation, optimiert werden kann. Die berechneten Auslegungsparameter können also eine Typbezeichnung eines Fensters umfassen.

In einer Ausführungsform des Verfahrens zum Auslegen einer Fensterkonstruktion an einem Bauprojekt ist vorgesehen, dass die Lichtsituation eine Zuordnung der Nettoglasflächen zu Himmelsrichtungen umfasst, wobei die Optimierung der Lichtsituation des Bauprojekts umfasst, eine Abweichung der Zuordnung der Nettoglasflächen zu einer vorgegebenen Ideal-Verteilung zu minimieren, wobei die vorgegebene Ideal-Verteilung insbesondere eine vorgegebene Ideal-Zuordnung von Nettoglasflächen zu Grund-Himmelsrichtungen umfasst.

Zum Beispiel kann eine vorgegebene Ideal-Verteilung 50% der Gesamt-Fensterfläche auf der Südseite, je 20% der Gesamt-Fensterfläche auf der Ost- und Westseite und 10% der Gesamt-Fensterfläche auf der Nordseite vorsehen. Sofern bei einer Bestands-Fensterkonstruktion des Bauprojekts ein Anteil von weniger als 50% der Gesamt-Fensterfläche auf der Südseite vorliegt, könnte eine Optimierung umfassen, z.B. auf der Süd-Seite Fensterkonstruktionen ohne Sprossen vorzuschlagen, um den Fensterflächenanteil zu erhöhen und somit näher an die 50% zu gelangen.

Allgemeiner gesprochen kann eine Zielfunktion definiert werden, die einen umso größeren Wert annimmt, je größer die Abweichung der Zuordnung der Fensterflächen zu Himmelsrichtungen von der Ideal-Verteilung ist.

In einer Ausführungsform des Verfahrens zum Auslegen einer Fensterkonstruktion an einem Bauprojekt ist vorgesehen, dass das Verfahren weiterhin die Schritte umfasst:

- Erfassen einer Gebäudeklasse des Bauprojekts aus einer vorgegebenen Liste von Gebäudeklassen, die umfasst: Einfamilienhaus, Doppelhaushälfte, Reiheneckhaus, Reihenmittelhaus, Mehrfamilienhaus mit weniger als 6 Wohneinheiten, und/oder Mehrfamilienhaus mit zumindest 6 Wohneinheiten, und/oder
- Erfassen einer Bauperiode des Gebäudes,

wobei das Verfahren vorzugsweise weiterhin umfasst, die Gebäudeklasse und/oder die Bauperiode basierend auf einem digitalen Bild des Bauprojekts zu bestimmen.

Anhand der Gebäudeklasse kann z.B. eine angepasste Energieberechnung oder Berechnung der Lichtsituation erfolgen. Anhand dieser Energieberechnung oder Berechnung der Lichtsituation können dann entsprechend die Fensteranteile bestimmt werden.

Die Bauperiode kann ebenfalls bei der Energieberechnung verwendet werden. Zum Beispiel können, wenn keine anderen Informationen über Dämmwerte des Gebäudes vorliegen, Standardwerte für die jeweilige Bauperiode verwendet werden. Dies hat den Vorteil, dass schnell eine erste Schätzung der Energiesituation erstellt werden kann, ohne dass der Benutzer konkrete Dämmwerte des Gebäudes kennen muss.

Die Bauperiode kann auch dazu verwendet werden um eine erste Schätzung zur Lichtsituation vorzunehmen. Weiterhin spielt sie eine Rolle bei der Auswahl von Fenstern, die zum Stil des Gebäudes passen.

Neben der Bauperiode können auch weitere Gebäudeeigenschaften abgefragt werden, wie z. B.: Hausart, Wohnfläche, Etagen, Material der existierenden Fensterrahmen, Verglasung, GPS-Ausrichtung des Hauses, Anzahl der Fenster pro Hausseite, Fenstertypen, Anzahl der Sprossen und Maße der Fenster. Außerdem kann eine IST- sowie SOLL-Licht-Situation erfasst werden.

In einer Ausführungsform des Verfahrens zum Auslegen einer Fensterkonstruktion an einem Bauprojekt ist vorgesehen, dass das Berechnen der Auslegungsparameter weiterhin umfasst, eine regionale Präferenzsituation zu optimieren, wobei insbesondere die Datenbank eine Zuordnung zwischen Fenstern und einer regionalen Präferenz umfasst.

Durch Berücksichtigung der Standortdaten (z.B. Klimazone, Einbruchsstatistik, regionale Präferenz, ...) als erste Ebene, eine Abfrage der Gebäudeeigenschaften als zweite Ebene und schließlich einer Abfrage der speziellen Kundenwünsche (z.B. individuelle Design-Vorlieben) kann die Bestimmung des vorzuschlagenden Fensters als Drei-Ebenen-Modell dargestellt werden. Die Informationen aus allen drei Ebenen können lokal auf der mobilen Vorrichtung oder in einer zentralen Datenbank in der Cloud hinterlegt werden. Ebenso kann das schließlich durch den Benutzer aus einer Datenbank von Fenstern ausgewählte Fenster in der Cloud hinterlegt werden. Eine weitere Anwendung, die auf einem anderen Endgerät ausgeführt wird, kann dann dazu ausgebildet sein, die hinterlegte Fenster-Auswahl abzufragen.

Basierend auf allen Informationen kann dann ein geeignetes Fenster vorgeschlagen werden. Hier kann zum einen das lokale Klima zur Energieberechnung herangezogen und zum anderen eine Verbindung zu regional typischen Profilsystemen über eine separate Datenbank hergestellt werden.

In einer Ausführungsform des Verfahrens zum Auslegen einer Fensterkonstruktion an einem Bauprojekt ist vorgesehen, dass das Verfahren weiterhin umfasst:

- Erfassen von geographischen Koordinaten des Bauprojekts,
- Bestimmen von klimatischen Parametern basierend auf den geographischen Koordinaten, wobei die klimatischen Parameter insbesondere über eine Zuordnung der geographischen Parameter zu einer von mehreren Klimazonen erfolgt,

wobei das Berechnen der Auslegungsparameter unter Berücksichtigung der klimatischen Parameter erfolgt, wobei die klimatischen Parameter insbesondere eine Jahres-Temperaturverteilung und/oder eine Jahres-Sonneneinstrahlungsverteilung umfassen.

Diese Ausführungsform hat den Vorteil, dass ortsabhängige klimatische Parameter berücksichtigt werden können, und somit eine Fensterkonstruktion ausgelegt werden kann, in Hinblick auf Energiesituation und Lichtverhältnisse optimal den örtlichen Gegebenheiten angepasst ist. Insbesondere können hierbei ein oder mehrere der ortsabhängigen Variablen: Windlast, Sonnenstunden, Sonnenwinkel, Strahlung, und Temperaturdifferenz berücksichtigt werden. Insbesondere können diese Variablen auch als Tageszeit-abhängige Kurven vorliegen und bei der Berechnung einer Zielfunktion berücksichtigt werden.

Für Deutschland kann eine Zuordnung der geographischen Koordinaten des Bauprojekts zu einer der 16 Klimazonen in Deutschland vorgesehen. Dem Anwender kann ein Vergleich vom Deutschen Durchschnitt mit seiner Klimazone angezeigt werden. Er kann weiterhin eine Aussage zu seiner Energiekosten-Ersparnis je nach ausgewähltem System im Vergleich zu den Altfenstern auf der mobilen Vorrichtung präsentiert bekommen.

Zum Beispiel kann bei einer, über den Tag gemittelten, hohen Temperaturdifferenz zwischen der üblichen Raumtemperatur und der Tageszeit-abhängigen Außentemperatur besonders gut dämmende Fenster vorgeschlagen werden.

Basierend auf den geographischen Koordinaten des Bauprojekts können auch Einbruchsstatistiken zu der Region, in der sich das Bauprojekt befindet, identifiziert und berücksichtigt werden. Zum Beispiel können in einer Region, die für Einbrüche gefährdet ist, speziell Einbruchsichere Fenster vorgeschlagen werden.

In bevorzugten Ausführungsformen umfasst das Verfahren einen Schritt, eine Zielfunktion zu optimieren. Mit anderen Worten, es wird das Fenster vorgeschlagen, mit dessen Kenndaten sich ein Optimum für die Zielfunktion ergibt.

Zum Beispiel kann die Zielfunktion eine gewichtete Summe sein. Die Summanden können Die Summanden dieser Summe können z.B. umfassen: einen Energie-Summand, der angibt wie vorteilhaft diese Fensterkonstruktion unter energetischen Gesichtspunkten ist, und einen Kostensummand, der angibt, wie hoch die Kosten für diese Fensterkonstruktionen sind. Gewichtungsfaktoren vor diesen beiden sogenannten können dann angeben, ob dem Benutzer die Kosten oder die energetische Bewertung der Fensterkonstruktion wichtiger sind. Somit kann eine beispielhafte Zielfunktion wie folgt dargestellt werden:

$$Score = w_1 S_1 + w_2 S_2 + \cdots$$

Hierbei ist "Score" der Wert der Zielfunktion für ein gegebenes Fenster, $w_1$ ist der Gewichtsfaktor für den ersten Summanden und $S_1$ der ungewichtete erste Summand. Zum Beispiel kann $S_1$ die erwartete Jahres-Heizenergie in kWh bei Verwendung der Fensterkonstruktion sein. Der zweite Summand $S_2$ kann die Anschaffungs- und/oder Installationskosten für die Fensterkonstruktion in Euro darstellen. Je nach Wahl der Gewichte $w_1$ und $w_2$ werden dabei unterschiedliche Fensterkonstruktionen zu einem optimalen (hier: niedrigen) Wert der Zielfunktion führen und somit von dem Verfahren als ideales Fenster vorgeschlagen werden.

Zumindest einer der Summanden der Zielfunktion berücksichtigt eine Lichtsituation, so dass im Ergebnis zumindest auch eine Lichtsituation optimiert wird. Die Lichtsituation kann z.B. als Teil der Energieoptimierung einfließen.

In einer optionalen Ausführungsform kann das Verfahren Energiekosten einlesen und somit selber bestimmen, wie Anschaffungskosten gegenüber der Energiesituation zu berücksichtigen sind. Zum Beispiel kann der Gewichtungsfaktor für die Anschaffungskosten relativ zum Gewichtungsfaktor für die energetische Bewertung so gesetzt werden, dass die in den nächsten 20 Jahren erwarteten Ersparnisse durch bessere Energiesituation in der Summe gleich gewichtet werden wie die höheren Anschaffungskosten.

In weiteren optionalen Ausführungsformen können weitere Summanden vorgesehen sein, zum Beispiel ein Summand, dessen Höhe davon abhängt, wie gut die Fensterkonstruktion stilistisch zu dem Gebäude passt. Auch hier kann ein zugehöriger Gewichtungsfaktor vorgesehen sein, sodass der Benutzer durch geeignete Wahl der Gewichtungsfaktoren einstellen kann, inwieweit Anschaffungskosten, energetische Optimierung und stilistische Überlegungen bei der Auslegung der Fensterkonstruktion zu berücksichtigen sind.

In einer Ausführungsform des Verfahrens zum Auslegen einer Fensterkonstruktion an einem Bauprojekt ist vorgesehen, dass das Optimieren der Lichtsituation umfasst:

- Berechnen von Nettoglasflächen zugeordnet zu Gebäudeseiten des Bauprojekts, und/oder
- Berechnen eines Verhältnisses von Nettoglasfläche zu einer Grundfläche des Bauprojekts und/oder einer Geschossanzahl des Bauprojekts.

In einer Ausführungsform des Verfahrens zum Auslegen einer Fensterkonstruktion an einem Bauprojekt ist vorgesehen, dass das Verfahren weiterhin umfasst:

- Aufnehmen eines digitalen Bildes einer Gebäudeseite des Bauprojekts, und
- automatische Identifizieren eines oder mehrerer Fenster in dem digitalen Bild, wobei vorzugsweise eine Schätzung der Glasfläche, insbesondere der Nettoglasfläche, des einen Fensters oder der mehreren Fenster erfolgt.

Bei dem Fenster kann es sich dabei auch um eine Fensteraussparung im Gebäude handeln, z.B. bei einem Rohbau. Es kann vorgesehen sein, dass das Identifizieren der Fenster in dem digitalen Bild umfasst, eine Gesamt-Fensterfläche zu bestimmen, wobei das Bestimmen umfasst, dass jedes der Fenster mit wenigstens zwei Referenzmarkern versehen wird, ein digitales Bild des Fensters mit den wenigstens zwei Referenzmarkern erzeugt wird; und auf Basis des digitalen Bildes die Abmessungen, insbesondere ein Aufmaß, umfassend Höhe und/oder Breite des Fensters bestimmt werden. Somit kann eine Gesamt-Fensterfläche genau bestimmt werden.

Vorzugsweise kann dabei das Fenster an wenigstens zwei, charakteristischen Stellen mit Referenzmarkern versehen werden. Vorzugsweise können dabei wenigstens zwei Referenzmarker reversibel an dem Fenster befestigt, insbesondere angeklebt, werden.

Vorzugsweise kann dabei vorgesehen sein, dass eine zu dem digitalen Bild des Fensters korrespondierende Form des Fensters erfasst wird und die Abmessungen auf Basis der erfassten Form bestimmt werden. Vorzugsweise kann dabei vorgesehen sein, dass die Form des Fensters unter Verwendung einer grafischen Benutzerschnittstelle, wie einem des Fensters unter Verwendung einer grafischen Benutzerschnittstelle, wie einem Touch-Display eines mobilen Endgeräts, wie ein Tablet-PC oder ein Smartphone, erfasst wird, wobei die grafische Benutzerschnittstelle das digitale Bild darstellt und eine auf die Form des Fensters bezogene Benutzereingabe registriert, wobei insbesondere die grafische Benutzerschnittstelle ferner eine zu der Form des Fensters korrespondierende Referenzgeometrie, wie ein Viereck, insbesondere ein Rechteck, darstellt.

Vorzugsweise kann dabei vorgesehen sein, dass ferner eine zu dem digitalen Bild des Fensters korrespondierende Perspektivinformation erfasst wird und die Abmessungen auf Basis der Perspektivinformation bestimmt werden.

Vorzugsweise kann dabei vorgesehen sein, dass wenigstens ein weiteres auf dem digitalen Bild abgebildetes Fenster, wie wenigstens ein Fenster oder wenigstens eine Tür, erkannt wird, und auf Basis des digitalen Bildes die Abmessungen, insbesondere einer Abmessung des wenigstens einen weiteren Fensters bestimmt werden.

Dies hat den Vorteil, dass der Benutzer die Informationen über die Fenster des Bauprojekts nicht manuell eingeben muss, sondern diese Informationen erfasst werden können, in dem der Benutzer eine Kamera einer mobilen Vorrichtung, wie zum Beispiel ein Smartphone oder Tablett-Computer, auf das Bauprojekt richtet.

Das automatische Identifizieren eines oder mehrerer Fenster in dem von der Kamera aufgenommenen Bild kann zum Beispiel durch ein neuronales Netz erfolgen, das mit Fotos von Gebäuden und darin markierten Fensterflächen trainiert wurde.

In alternativen Ausführungsformen kann vorgesehen sein, dass die mobile Vorrichtung eine 3D-Aufnahmevorrichtung wie z.B. ein LIDAR aufweist. Somit können Aussparungen und Vertiefungen in der Gebäudeoberfläche automatisch identifiziert werden. Diese Aussparungen und Vertiefungen sind zumindest möglicherweise für Fensterflächen vorgesehen. Somit kann vorgesehen sein, dass dem Benutzer diese identifizierten Aussparungen und/oder Vertiefungen angezeigt werden und der Benutzer auswählen kann, ob es sich hierbei wirklich um eine Fensterfläche handelt. Somit liegt ein semiautomatisches Verfahren vor, mit dem eine effiziente Erfassung bei gleichzeitig hoher Genauigkeit erzielt werden kann.

In einer Ausführungsform des Verfahrens zum Auslegen einer Fensterkonstruktion an einem Bauprojekt ist vorgesehen, dass das Verfahren weiterhin umfasst:

- Ausgeben einer ersten Benutzeraufforderung, um einen Benutzer aufzufordern, eine mobile Vorrichtung in eine horizontale Orientierung zu bringen, und/oder
- Ausgeben einer zweiten Benutzeraufforderung, um den Benutzer aufzufordern, die mobile Vorrichtung in eine vertikale Orientierung zu bringen.

Das Ausgeben der Benutzeraufforderungen hat den Vorteil, dass der Benutzer durch die Bedienungsschritte geführt wird und somit Fehlbedienungen vermieden werden können.

Nach der ersten Benutzeraufforderung bringt der Benutzer die mobile Vorrichtung in eine horizontale Orientierung, die häufig am besten geeignet ist um mit einem in der mobilen Vorrichtung vorgesehenen Kompass eine Orientierung relativ zu Norden zu bestimmen.

Mit der zweiten Benutzer Aufforderung wird der Benutzer aufgefordert, die mobile Vorrichtung in eine vertikale Orientierung zu bringen, die häufig am besten dazu geeignet ist, um ein Foto mit einem auf der Rückseite der mobilen Vorrichtung vorgesehenen Kamera aufzunehmen.

Dadurch, dass die erste Benutzeraufforderung und die zweite Benutzeraufforderung vorzugsweise zeitnah hinein hintereinander, zum Beispiel innerhalb von zehn Sekunden, vorzugsweise innerhalb von drei Sekunden, ausgegeben werden, kann sichergestellt werden, dass die in der horizontalen Orientierung aufgenommene Himmelsausrichtung und das in der vertikalen Orientierung aufgenommene Bild zu einer gleichen oder kaum veränderten Position des Benutzers korrespondieren.

Die Erfassung der Geräuschsituation hat den Vorteil, dass neben der Lichtsituation und einer energetischen Optimierung gleichzeitig auch eine Optimierung hinsichtlich einer Geräuschsituation erfolgen kann.

Insbesondere kann vorgesehen sein, dass eine zu optimierende Zielfunktion, anhand derer eine vorgeschlagene Fensterkonstruktion bestimmt wird, einen Summanden umfasst, der eine Geräuschsituation widerspiegelt. Insbesondere kann der Summand proportional zu einem Lärmpegel an einem Ort innerhalb des Gebäudes sein. Somit kann berücksichtigt werden, dass eine bestimmte Fensterkonstruktion zwar energetisch vorteilhaft sein kann, dafür aber unter Umständen nicht ganz so gute akustische Dämmwerte liefert.

In einer optionalen Ausgestaltung kann vorgesehen sein, dass eine Gewichtung des Geräusch-Summanden umso höher ist, je höher ein durch das Mikrophon erfasster Geräuschpegel im Außenraum des Bauprojektes ist. Somit kann eine schallisolierende Wirkung einer Fensterkonstruktion umso mehr berücksichtigt werden, je höher ein Lärm im Außenbereich des Gebäudes ist.

Vorzugsweise erfolgt hier eine Anpassung des Geräuschpegels basierend auf einer Tageszeit und/oder einem Wochentag, an dem der Geräuschpegel erfasst wurde. Zum Beispiel kann vorgesehen sein, dass wenn am Wochenende vormittags bereits ein hoher Geräuschpegel erfasst wurde, dies stärker berücksichtigt wird, als wenn an einem Werktag morgens, d. h. während dem zu erwartenden Berufsverkehr, ein hoher Geräuschpegel erfasst wurde.

In vorteilhaften Ausführungsformen kann vorgesehen sein, dass verschiedene Arten von Geräuschen unterschieden werden. Zum Beispiel kann vorgesehen sein, dass Autolärm als solcher erkannt wird und dann besonders schallisolierende Fensterkonstruktionen vorgeschlagen werden. Dies kann zum Beispiel umgesetzt werden, indem ein Gewichtungsfaktor für den Geräusch-Summanden besonders hoch gewählt wird, wenn Autolärm oder Autolärm mit einem Geräuschpegel über einem bestimmten Grenzwert erkannt wurde.

In einer Ausführungsform des Verfahrens zum Auslegen einer Fensterkonstruktion an einem Bauprojekt ist vorgesehen, dass das Erfassen des Geräuschpegels anhand einer Geo-Datenbank über Lärmquellen, insbesondere anhand eines Karten-Diensts mit Informationen über einen Verlauf und/oder eine Verkehrsbelastung von Straßen, erfolgt.

Der erwartete durch eine Straße verursachte Geräuschpegel kann z.B. geschätzt werden anhand der Breite der Straße oder anhand einer von einem Kartenservice abgefragten Verkehrsintensität auf der Straße. Dies hat den Vorteil, dass keine Messung mit einem Mikrophon mehr erforderlich ist.

In einer Ausführungsform des Verfahrens zum Auslegen einer Fensterkonstruktion an einem Bauprojekt ist vorgesehen, dass das Verfahren weiterhin umfasst:

- Detektieren einer Mikrophon-Fehlersituation, insbesondere einer Situation eines durch eine Hand eines Benutzers abgedecktes Mikrophon, und
- Ausgeben eines Aufforderungssignals an einen Benutzer, um den Benutzer zur Korrektur der Mikrophon-Fehlersituation aufzufordern.

Dies hat den Vorteil, dass vermieden werden kann, dass durch ein abgedecktes Mikrophon fehlerhafte (zu niedrige) Geräuschpegel erfasst werden.

In einer Ausführungsform des Verfahrens zum Auslegen einer Fensterkonstruktion an einem Bauprojekt ist vorgesehen, dass das Verfahren weiterhin umfasst eine Normierung des durch ein Mikrophon der mobilen Vorrichtung aufgenommenen Geräuschs vorzunehmen, wobei die Normierung insbesondere durch eine Zuordnung von Typen von mobilen Vorrichtungen zu Geräusch-Sensitivitäten der mobilen Vorrichtungen erfolgt.

In einer weiteren Ausführungsform ist vorgesehen, dass das Verfahren weiterhin umfasst, eine optimale Lüftungsfrequenz zu bestimmen. Insbesondere kann eine Kombination von einer oder mehreren der folgenden Informationen verwendet werden um eine optimale Lüftungsfrequenz zu bestimmen: geographische Koordinaten, individuelle Angaben zur Fläche, Räumen, Wunschtemperatur, Position der Fenster, übliche Lüftungsstellung und Anzahl Personen. Vorzugsweise werden alle genannten Informationen berücksichtigt. Die Informationen können zum Beispiel von dem Benutzer über eine graphische Benutzeroberfläche eingegeben werden. Ebenso kann die bestimmte optimale Lüftungsfrequenz auf der Benutzeroberfläche dargestellt werden.

Insbesondere kann die Lüftungsfrequenz optimal sein in Bezug auf Energieeinsparung, Pollenflug, Unwetter und/oder Einbruchschutz.

Die optimale Lüftungsfrequenz kann bestimmt werden als eine gewichtete Funktion der für die einzelnen Aspekte optimalen Lüftungsfrequenzen. Die optimale Lüftungsfrequenz kann als Zahl (z. B. 2-mal pro Tag) berechnet werden oder es können optimale Lüftungszeiten bestimmt werden, z.B.: kann bestimmt werden, dass zwischen 09:00 und 10:00 und zwischen 15:00 und 16:00 gelüftet werden sollte.

Zur Bestimmung der optimalen Lüftungszeiten können ideale Lüftungszeiten für jeden einzelnen Aspekt bestimmt werden und diese summiert oder gewichtet summiert berücksichtigt werden um die insgesamt optimalen Lüftungszeiten zu bestimmen. Zum Beispiel könnte vorgegeben sein, dass unter dem Aspekt des Einbruchsschutzes idealerweise nur tagsüber gelüftet werden sollte. Unter dem Aspekt des Pollenschutzes sollte in der Stadt nur zwischen 06:00 und 08:00, in ländlichen Gebieten dagegen nur zwischen 19:00 und 24:00 gelüftet werden. Ob das Gebäude in der Stadt oder in einer ländlichen Gegend liegt, kann dabei über geographische Koordinaten und einen Kartendienst wie Google Maps bestimmt werden. In Bezug auf den Aspekt Energieeinsparung kann idealerweise nur am Tag oder am Nachmittag gelüftet werden, wenn die Außentemperaturen nicht zu hoch sind. Unter dem Aspekt des Schutzes vor Unwetter kann empfohlen werden, nur dann zu lüften, wenn eine Wettervorhersage (z.B. abgefragt von einem Internet-Server) kein Regen oder nur eine geringe Niederschlagsmenge vorhersagt, z.B. eine vorhergesagte Niederschlagsmenge, die geringer ist als ein bestimmter Grenzwert.

Die optimalen Lüftungszeiten können also automatisch nicht nur auf den einmalig eingegebenen festen Informationen basieren, sondern können auch aktuelle Informationen wie Regenfall, Windgeschwindigkeit, Außentemperatur, Innentemperatur, Pollenflug, Schadstoffkonzentration in der Luft, $CO_2$ Gehalt in dem Gebäude und weitere Informationen berücksichtigen.

Zum Beispiel kann vorgesehen sein, dass bei einem bestimmten $CO_2$ Gehalt, zum Beispiel über 1000 ppm, immer vorgeschlagen wird, zu lüften. Der $CO_2$ Gehalt kann über geeignete Sensoren in dem Gebäude bestimmt werden, bzw. es kann vorgesehen sein, dass die mobile Vorrichtung die Informationen über den $CO_2$ Gehalt von einem vernetzten Smart Home System abfragt. Zum Beispiel kann die mobile Vorrichtung realisiert sein als eine App auf einem Smartphone und das Smartphone kann sich per WLAN mit dem Smart Home System verbinden.

Weitere Informationen, zum Beispiel eine oder mehrere von Regenfall, Windgeschwindigkeit, Außentemperatur, Pollenflug und Schadstoffkonzentration in der Luft können über das Internet von geeigneten Informationsdiensten abgefragt werden und stehen somit minutengenau zur Verfügung. Hierzu können die geographischen Koordinaten des Gebäudes an einen zentralen Server geschickt werden, der die Informationen zu diesen Koordinaten dann an die mobile Vorrichtung sendet. Alternativ kann auch die Berechnung der optimalen Lüftungszeiten auf dem zentralen Server erfolgen.

Die optimale Lüftungszeit kann bestimmt werden als die Lüftungszeiten, bei denen alle Einzelbedingungen erfüllt sind. Alternativ kann eine Summe für Lüftungsempfehlungen für jeden Zeitraum bestimmt werden. Zum Beispiel kann dabei bestimmt werden, dass zwischen 06:00 und 08:00 aus drei Aspekten empfohlen wird zu lüften und dies somit insgesamt eine empfohlene Lüftungszeit darstellt. Mit anderen Worten, es kann bestimmt werden, wann die Zahl der Lüftungszeit-Empfehlungen für verschiedene Aspekte größer ist als ein Grenzwert. Die Summierung der Einzelempfehlungen kann gewichtet sein. Zum Beispiel kann ein Benutzer eingeben, dass Pollenschutz und/oder Einbruchsschutz besonders wichtig sind und diese somit besonders gewichtet werden sollen. In diesem Fall könnte vorgesehen sein, dass die gewichtete Summe der Einzelempfehlungen für einen bestimmten Zeitraum größer sein muss als ein Grenzwert, damit diese Zeit als optimale Lüftungszeit empfohlen wird.

Bei der Bestimmung der Lüftungszeiten kann das Verfahren berücksichtigen, ob die Fenster lediglich kippbar sind, und insofern nur einen geringen Luftstrom zulassen, oder ob die Fenster ganz geöffnet werden können. Sofern die Fenster lediglich kippbar sind, kann für die optimalen Öffnungszeiten eine längere Öffnungsdauer empfohlen werden. Zum Beispiel kann das Verfahren einen Verfahrensschritt umfassen, basierend auf den maximalen Fenster-Öffnungszuständen einen maximalen Gesamt-Luftstrom zu bestimmen und die optimale Öffnungsdauer so vorzuschlagen, dass bei üblichen Windverhältnissen ein vollständiger Austausch der Luft im Wohnraum möglich ist. Somit ergibt sich bei vielen Fenstern, die lediglich kippbar sind, ein geringer Gesamt-Luftstrom und somit eine optimale lange Öffnungszeit und bei viele Fenstern, die vollständig geöffnet werden können, ein hoher Gesamt-Luftstrom und somit eine optimale kürzere Öffnungszeit.

In einer bevorzugten Ausführungsform ist vorgesehen, dass das Verfahren vorsieht, zum Zeitpunkt einer empfohlenen Lüftungszeit, z. B. wenn eine empfohlene Lüftungszeitspanne beginnt, eine Benutzeraufforderung auszugeben. Die Benutzeraufforderung kann zum Beispiel ein Signalton und/oder ein Vibrationssignal einer mobilen Vorrichtung sein. Somit wird der Benutzer an das Lüften erinnert.

Die Wunschtemperatur kann derart berücksichtigt werden, dass immer dann, wenn die (gemessene oder vorhergesagte) Umgebungstemperatur näher an der Wunschtemperatur ist als die aktuelle Innenraumtemperatur, ein Lüften empfohlen wird.

Um den Benutzer nicht unnötig mit Benutzeraufforderungen zu belästigen, kann weiterhin vorgesehen sein, dass das Verfahren von einem Smart Home System Informationen über einen Öffnungszustand der Fenster abfragt. Zum Beispiel können an den Fenstern Öffnungssensoren angebracht sein, die den Öffnungszustand des Fensters erkennen und an eine zentrale Einheit des Smart Home Systems übertragen. Diese Information kann wiederum durch die mobile Vorrichtung von der zentralen Einheit abgefragt werden und es kann vorgesehen sein, dass die mobile Vorrichtung eine Benutzeraufforderung nur dann ausgibt, wenn eine empfohlene Belichtungszeit vorliegt, aber die Fenster nicht geöffnet sind, bzw. die Zahl der geöffneten Fenster unter einem vorbestimmten Grenzwert liegt.

In bevorzugten Ausführungsformen kann vorgesehen sein, dass während der optimalen Lüftungszeit ein elektronisches Signal ausgegeben wird, um eine Lüftungssteuerung zu steuern um ein oder mehrere Fenster in eine Lüftungsstellung zu bringen. Zum Beispiel kann dieses Signal per Funk, insbesondere über WLAN, übertragen werden.

Somit kann zu den optimalen Lüftungszeiten eine automatische Ansteuerung der Fenster vorgenommen werden und sichergestellt werden, dass immer optimal gelüftet wird. Insbesondere kann somit bereits in den frühen Morgenstunden gelüftet werden, ohne dass die Bewohner bereits früh aufstehen müssen.

Die Lüftungssteuerung kann dabei, z. B. wenn Einbruchsschutz priorisiert ist, so konfiguriert werden, dass nur dann gelüftet wird, wenn die Bewohner anwesend sind, was z.B. über Infrarotsensoren detektiert werden kann.

In einer weiteren Ausführungsform ist vorgesehen, dass das Verfahren umfasst, dass weitere Daten zu dem Bauprojekt aufgenommen werden. Diese Daten und die Nutzung der App selbst lassen dabei auch Rückschlüsse auf den Kundentypen zu. Insbesondere können die aufgenommenen Daten basierend auf Datenbanken, z.B. eine Datenbank auf einem Server, durch weitere Information angereichert werden (z.B. Immobilienwerte, Kaufkraftindikatoren, regionale Baukosten, weiteren Marktdaten Daten aus Bauvorschriften, Vergleich mit Daten anderer Projekte in der App) und in einem weiteren Verarbeitungsschritt so aufbereitet werden, dass z.B. auf einem Server, an den die Daten des Bauprojekts übertragen werden, eine Qualifizierung der Anfrage erfolgen kann.

Die Kundenanfrage bzw. das dazu korrespondierende Bauprojekt kann zentral erfasst und gemäß der Qualifizierung gerankt werden. Insbesondere können dabei spezifische Bearbeitungsstrategien vorgeschlagen werden. Die Bearbeitung kann dann durch eine Schnittstelle in ein CRM System oder ein integriertes CRM Modul systematisiert werden. Somit kann der Fensterverkäufer bzw. Monteur sich auf die richtigen Projekte konzentrieren und die Kundenanfragen entsprechend ihrer Potentiale richtig bearbeiten. Auch kann ein Gewinn des Verkäufers gesteigert werden.

Die Qualifizierung des Bauprojekts kann anhand einer Kundenqualifizierung (z.B. finanzielles Potential und/oder Involvement des Kunden) und/oder durch den Projekttyp (z.B. Projektumfang und/oder Dringlichkeit) erfolgen. Da bei kann das Ranking, d.h. die Priorisierung der Bauprojekte auf einer systematischen Aufnahme von Projekttypen und Kundentypen erfolgen.

Insbesondere kann eine Projektqualifizierung basierend auf der Dimension Dringlichkeit und/oder der Dimension "potentielles Projektvolumen" erfolgen.

Das (potentielle) Projektvolumen kann bestimmt werden basierend auf einer oder mehreren der folgenden Informationen: Kalkulation Basis (Flex B), Kalkulation Potential (vorgeschlagene Kombination), Zusätzliches Potential - Neubau bzw. Komplettumbau, bei dem Fensterflächen vergrößert werden können, wenn Belichtungswerte suboptimal sind, Sonderthemen (Haustür, HST) RC 2/3, Sonnenschutz, Rollläden, Interesse an Oberflächen.

Die Dringlichkeit kann bestimmt werden basierend auf einer oder mehreren der Informationen: Abstimmung mit anderen Gewerken (Neubau, Komplettrenovierung (Fassade und Heizung)) oder dem Vorliegen von aktuell undichten Fenster. Eine geringe Dringlichkeit kann angenommen werden bei einer energetischen Optimierung nur von Fenstern und/oder dem Austausch einzelner Fenster.

Das Verfahren kann umfassen, eine oder mehrere der oben genannten Information auf einer mobilen Vorrichtung zu erfassen und von der mobilen Vorrichtung an einen zentralen Server zu übertragen.

Eine Kundenqualifizierung kann entlang der Dimensionen finanzielles Potential und/oder Involvement erfolgen. Dabei kann das finanzielle Potential erkannt werden basierend auf einer oder mehreren der Information: Immobilientyp (Mehrfamilienhaus, Einfamilienhaus, Reihenhaus, Doppelhaus), Immobilienwerte PLZ (Immoscout, Immowelt, etc.), Kaufkraft basierend auf PLZ (destatis). Insbesondere kann hierzu z.B. ein Gebäudetyp, eine PLZ oder sonstige Ortsinformation (z.B. Koordinate) auf der mobilen Vorrichtung erfasst werden. Zum Beispiel kann eine Erfassung der Ortsinformation durch einen Sensor für ein Navigationssatellitensystem erfasst werden.

Ein Involvement des Kunden kann durch eine oder mehrere der Informationen: Dauer der Nutzung der App, Detaillierung von Eingaben, Wahl von Varianten und/oder Investment (Mehrfamilienhaus) oder eigengenutzte Immobilie erfolgen.

Insbesondere kann eine Priorisierung durch eine gewichtete Summierung einer oder mehrere Werte wie Quadratmeterzahl, Immobilienwert, Baukosten, Standortfaktor, relative Fensterkosten, und/oder Projektkosten erfolgen, um so ein Rating zu bestimmen und basierend auf dem Rating ein Ranking verschiedenerer Bauprojekte zu bestimmen.

Projekte können nach Projektgröße angepasst und um Standortfaktor und relative Projektgröße skaliert priorisiert werden.

Insbesondere kann das Verfahren umfassen, Benutzungsparameter, insbesondere eine Benutzungsdauer des Benutzers beim Erfassen der Informationen, zu erfassen und an den Server zu übertragen. Somit können auch die Benutzungsparameter bei der Bearbeitung des Bauprojekts berücksichtigt werden.

Vorzugsweise umfasst das Verfahren weiterhin, dass der Server die erfassten Bauprojekte an ein oder mehrere mobile Ziel-Vorrichtungen zum Informieren eines Fensterverkäufers und/oder Monteurs überträgt. Insbesondere kann dabei die Übertragung an die Ziel-Vorrichtungen in einer Reihenfolge erfolgen, die auf dem Rating der Bauprojekte basiert.

Vorzugsweise weist die mobile Ziel-Vorrichtung ein Benachrichtigungsmodul auf, um den Fensterverkäufer und/oder Monteur auf das eingegangene Bauprojekt zu informieren. Insbesondere kann die Benachrichtigung dann erfolgen, wenn ein besonders hohes Rating, z.B. basierend auf einer hohen bestimmten Dringlichkeit, vorliegt, insbesondere mit einer Dringlichkeit höher als eine vorgegeben Grenzwert-Dringlichkeit. Somit kann eine technische Lösung bereitgestellt werden, mit der sichergestellt wird, dass dringliche Projekte beschleunig bearbeitet werden.

Weiterhin stellt die Erfindung eine mobile Vorrichtung zum Auslegen einer Fensterkonstruktion an einem Bauprojekt bereit, umfassend:

- eine Himmelsrichtung-Erfassungsschnittstelle zum Erfassen einer Himmelsrichtung zumindest einer Gebäudeseite des Bauprojekts,
- eine Fensterflächen-Erfassungsschnittstelle von Fensterflächen der Fensterkonstruktion zugeordnet zu Gebäudeseiten des Bauprojekts,
- eine Berechnungs-Einheit zum Berechnen von Auslegungsparametern der Fensterkonstruktion basierend auf den erfassten Daten und einer Datenbank von Fenstern, wobei die Berechnung der Auslegungsparameter umfasst, eine Lichtsituation des Bauprojekts zu optimieren, und
- eine Geräusch-Erfassungseinheit zum Erfassen eines Geräuschpegels im Innen- und/oder Außenraum des Bauprojekts, unter Verwendung eines Mikrophons der mobilen Vorrichtung, wobei das Berechnen der Auslegungsparameter umfasst, eine Geräuschsituation des Bauprojekts zu optimieren.

In einer Ausführungsform der mobilen Vorrichtung zum Auslegen einer Fensterkonstruktion an einem Bauprojekt ist vorgesehen, dass die Himmelsrichtung-Erfassungsschnittstelle einen Kompass umfasst, die Fensterflächen-Erfassungsschnittstelle eine Digitalkamera umfasst, und/oder die Vorrichtung weiterhin ein Mikrofon Erfassen eines Geräuschpegels im Innen- und/oder Außenraum des Bauprojekts umfasst.

Weiterhin stellt die Erfindung ein System bereit, umfassend eine oben genannte mobile Vorrichtung, und einen Server, wobei die mobile Vorrichtung dazu ausgebildet ist, erfasste Informationen und/oder Benutzungsparameter an den Server zu übertragen und

wobei der Server dazu ausgebildet ist, eine Priorisierung von Bauprojekten basierend auf den erfassten Informationen und/oder Benutzungsparametern durchzuführen. Vorzugsweise kann die Priorisierung an eine mobile Zielvorrichtung übertragen werden und/oder ein Bauprojekt basierend auf der Priorisierung übertragen werden.

Weitere Aspekte der Erfindung sind in den Unteransprüchen angegeben. Weitere Vorteile, Merkmale und Aspekte der Erfindung sind durch die folgende Beschreibung einer bevorzugten Ausführung der Erfindung anhand der beiliegenden Zeichnungen erläutert, wobei:

FIG. 1          zeigt eine schematische Darstellung einer Erfassung einer Himmelsrichtung einer Gebäudeseite und weiterer Informationen eines Bauprojekts,

FIG. 2          zeigt eine schematische Darstellung einer Erfassung weiterer Informationen eines Fensters eines Bauprojekts,

FIG. 3          zeigt eine schematische Darstellung einer mobilen Vorrichtung zum Erfassen von Informationen eines Bauprojekts, umfassend einen Geräuschpegel,

FIG. 4a, 4b und 4c    zeigen verschiedene Darstellungen einer Benutzeroberfläche einer mobilen Vorrichtung zum Erfassen von Informationen eines Bauprojekts, umfassend eine Klimazone, und Fenster auf Gebäudeseiten, und

FIG. 5          zeigt eine Benutzeroberfläche einer weiteren mobilen Vorrichtung, mit der insbesondere eine Geräuschsituation erfasst wird.

In den folgenden Darstellungen bevorzugter Ausführungen der Erfindung werden dieselben oder ähnliche Bezugszeichen für dieselben oder ähnliche Komponenten verwendet, um die Lesbarkeit der Beschreibung zu vereinfachen.

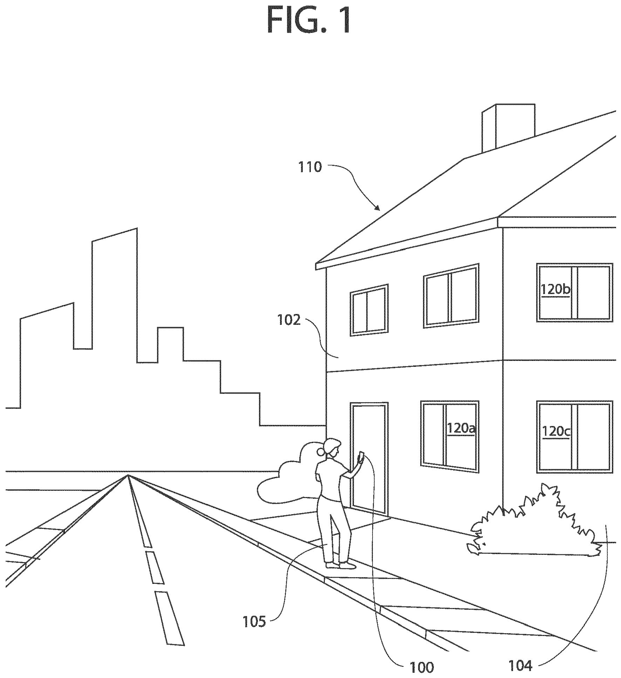

FIG. 1 ist eine schematische Darstellung einer Erfassung einer Himmelsrichtung einer Gebäudeseite und weiterer Informationen eines Bauprojekts. Ein Bauprojekt 110, hier ein bereits fertiggestelltes Gebäude 110, das renoviert werden soll, befindet sich neben einer Straße. Eine Vorderseite 102 des Gebäudes ist der Straße zugewandt. Eine Person 105 benutzt eine mobile Vorrichtung 100, hier ein Smartphone, um digitale Bilder von der Vorderseite 102 des Gebäudes 110 aufzunehmen. Insbesondere erfasst sie dabei das Fenster 120a, das auf der Vorderseite des Gebäudes 110 angeordnet ist. Hierzu hält sie das Smartphone 100 in im Wesentlichen vertikaler Orientierung. Zeitgleich mit dem Aufnehmen der digitalen Bilder erfasst das Smartphone 100 eine Himmelsrichtung. Das Smartphone 100 kann somit das Fenster 120a der gemessenen Himmelsrichtung zuordnen. Vorteilhafterweise wird also ein Datensatz gespeichert, in dem sowohl das Bild des Fensters, identifizierte Abmessungen des Fensters und die Himmelsrichtung gespeichert werden. Die Identifikation der Abmessungen des Fensters kann entweder durch eine Eingabe durch die Benutzerinnen erfolgen oder durch eine automatische Erfassung. Die automatische Erfassung der Abmessungen kann zum Beispiel durch eine Abstandsmessung durch einen 3D Sensor der mobilen Vorrichtung erfolgen.

Das Gebäude weist auf einer weiteren, nicht der Straße zugewandten Gebäudeseite 104 weitere Fenster 120b und 120c auf. Die mobile Vorrichtung kann also dazu verwendet werden, auch von diesen Fenstern die Abmessungen und Himmelsrichtung der Gebäudeseite zu erfassen.

Insbesondere kann also die Benutzerin einmal um das Gebäude 110 herumlaufen, um der Reihe nach alle Fenster des Gebäudes zu erfassen. Hierbei kann vorgesehen sein, dass bei jeder Gebäudeseite die Himmelsrichtung bestimmt wird.

Vorteilhafterweise kann dabei vorgesehen sein, dass die mobile Vorrichtung eine Anpassung der möglicherweise nicht genau erfassten Himmelsrichtungen vornimmt. Zum Beispiel, wenn einer Ausrichtungs-Differenz zwischen einer Gebäudeseite und einer nächsten Gebäudeseite nicht 90° beträgt, sondern davon um wenige Grad abweicht, kann davon ausgegangen werden, dass es sich hierbei um einen Messfehler handelt. Somit kann anhand der Annahme, dass benachbarte Gebäudeseiten typischerweise im Winkel von 90° zueinanderstehen, eine Korrektur der gemessenen Himmelsrichtungen erfolgen. Zum Beispiel kann vorgesehen sein, dass eine derartige Korrektur bei Abweichungen von bis zu +/- 10° erfolgt. Bei größeren Abweichungen ist hingegen davon auszugehen, dass die Gebäudeseiten möglicherweise nicht rechtwinklig zueinanderstehen. In diesem Fall kann der Benutzer dazu aufgefordert werden eine erneute Messung der Himmelsausrichtung mittels des Kompasses der mobilen Vorrichtung vorzunehmen, um einen Messfehler auszuschließen.

Weiterhin kann vorgesehen sein, dass die mobile Vorrichtung bei jeder Aufnahme eines Fensters gleichzeitig auch eine Geräuschmessung vornimmt. Der Benutzer kann durch ein Signal, zum Beispiel ein Symbol auf einer Anzeige der mobilen Vorrichtung, darauf hingewiesen werden, dass eine Geräuschmessung vorgenommen wird. Hierdurch kann der Benutzer dazu aufgefordert werden, während der Geräuschmessung nicht zu sprechen oder andere Geräusche zu erzeugen.

Die Aufzeichnung der gemessenen und/oder vom Benutzer eingegebenen Informationen kann auf der mobilen Vorrichtung 100 oder in der Cloud erfolgen.

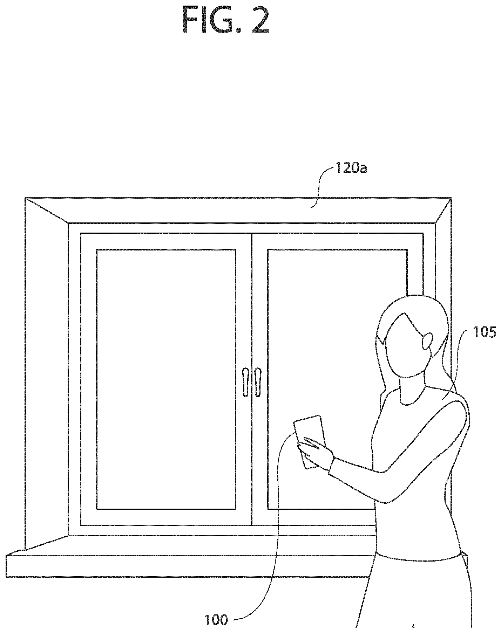

FIG. 2 ist eine schematische Darstellung einer Erfassung weiterer Informationen eines Fensters eines Bauprojektes. Hierbei befindet sich die Benutzerin 105 im Inneren des Gebäudes und verwendet die mobile Vorrichtung 100 um von ihnen ein Bild des Fensters 120a aufzunehmen und gleichzeitig eine Geräuschmessung vorzunehmen. Somit kann eine Geräuschmessung im Innenraum vor dem Fenster 120a mit einer Geräuschmessung im Außenraum vor dem Fenster 120a verglichen werden. Aus dieser Differenz kann eine Schätzung für die Schallisolierung eines bereits vorhandenen Fensters 120a bestimmt werden.

Alternativ kann vorgesehen sein, dass eine Geräuschmessung nur im Inneren des Gebäudes stattfindet, der Benutzer durch die mobile Vorrichtung aber aufgefordert wird, eine Messung bei geöffnetem Fenster und eine weitere Messung bei geschlossenem Fenster durchzuführen. Somit kann die Schallisolierung der vorhandenen Fensterkonstruktion bestimmt werden.

Ebenso kann die Fensterfläche des Fensters 120a sowohl von Ihnen als auch von außen anhand von einem 3D-Sensor und/oder einem 3D-Sensor in Kombination mit einer Kamera bestimmt werden. Die Mehrfacherfassung hat den Vorteil, dass die Messwerte von innen und von außen abgeglichen werden können. Im Fall von geringen Abweichungen kann der Durchschnitt verwendet werden oder im Fall von größeren Abweichungen kann der Benutzer durch einen Aufforderung Signal dazu aufgefordert werden, eine Messung zu wiederholen, da eventuell ein Messfehler vorliegt.

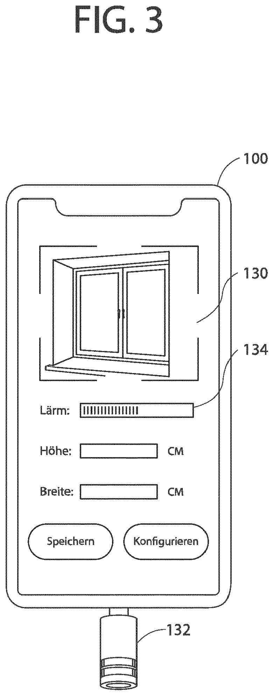

FIG. 3 zeigt eine schematische Darstellung einer mobilen Vorrichtung zum Erfassen von Informationen eines Bauprojekts, wobei die Information einen Geräuschpegel umfasst. Die Benutzeroberfläche umfasst einen Bereich unter 30, in dem das aufgenommene digitale Bild des Fensters dargestellt wird. Dies erlaubt dem Benutzer, sich zu vergewissern, zu welchem Fenster gerade Informationen erfasst werden. Die Benutzeroberfläche umfasst weiterhin einen Pegelindikator 134, der durch unterschiedlich viele Balken anzeigt, was für einen Geräuschpegel momentan gemessen wird.

Bei der mobilen Vorrichtung 100 aus FIG. 3 handelt es sich um ein herkömmliches Smartphone. Da herkömmliche Smartphones nicht immer zur präzisen Geräuschpegelmessung geeignet sind, verwendet das Smartphone 100 ein Ansteckmikrophon 132, das an eine Buchse des Mikrofons, z.B. eine 3,5mm Klinkenbuchse oder eine USB-C Buchse, angesteckt wird.

In anderen Ausführungsformen wird das integrierte Mikrophon des Smartphones verwendet. Hierbei kann eine Umrechnung des Signals des Mikrophons auf normierte dB-Werte über eine Zuordnungstabelle (basierend auf dem bekannten Smartphone-Typ) erfolgen.

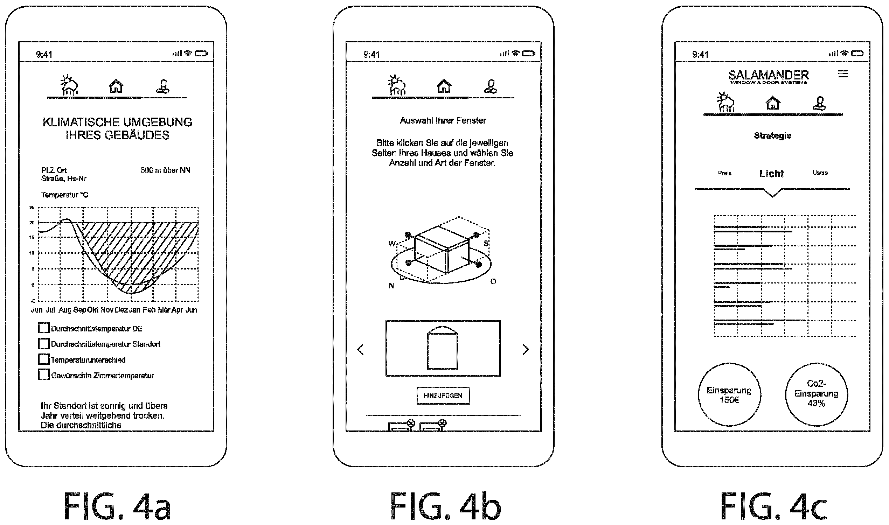

FIG. 4a zeigt eine Benutzeroberfläche des Smartphones, die Klimadaten eines eingegebenen Standorts darstellt. Insbesondere wird ein jährlicher Verlauf der Durchschnittstemperatur und eine Differenz der Durchschnittstemperatur zur gewünschten Zimmertemperatur (hier: 20°C) dargestellt. Die Fläche zwischen der gewünschten Zimmertemperatur und der Durchschnittstemperatur (soweit sie unter der gewünschten Zimmertemperatur liegt) ist schraffiert dargestellt. Die schraffierte Fläche kann somit, in Kombination mit der Information über den Isolierwert der Fenster, eine Schätzung für den jährlichen Heizbedarf darstellen.

FIG. 4b zeigt eine Benutzeroberfläche des Smartphones zur Eingabe der Anzahl und Art der Fenster, zugeordnet zu den Gebäudeseiten des Bauprojekts. Durch Anklicken einer Gebäudeseite der symbolischen Darstellung des Gebäudes kann der Benutzer diese Gebäudeseite zur Eingabe auswählen. Somit können die Informationen über die Anzahl und Art der Fenster eingegeben werden, auch wenn der Benutzer gerade nicht bei dem Bauprojekt vor Ort ist.

FIG. 4c zeigt eine Benutzeroberfläche, bei der nach Erfassung der Information über das Bauprojekt ein Vergleich zwischen den vorhandenen Fenstern und der vorgeschlagenen Fensterkonstruktion graphisch dargestellt wird. Insbesondere werden für Preis, Authentizität, Uw-Wert, Nutzbarkeit, Energie-Eintrag und Licht absolut jeweils ein Balken für die bisherige Situation und ein Balken für die Situation mit der vorgeschlagenen neuen Fensterkonstruktion gezeigt. Somit bekommt der Benutzer einen schnellen Überblick über die Vorteile der vorgeschlagenen neuen Fensterkonstruktion.

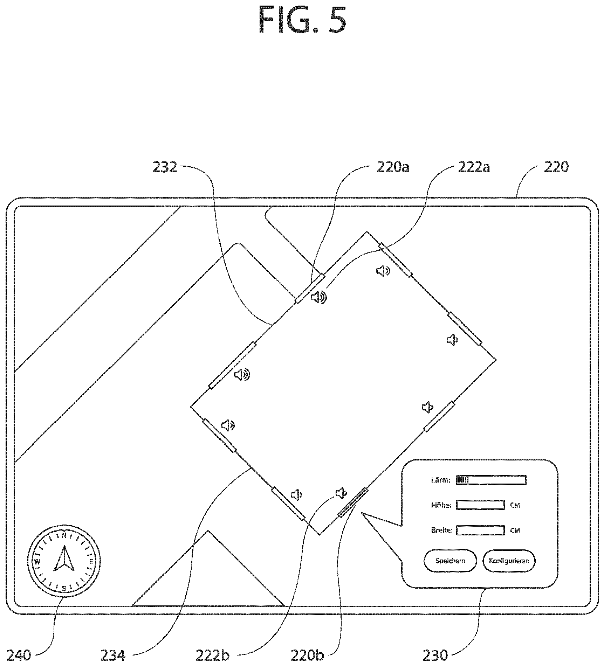

FIG. 5 zeigt eine Benutzeroberfläche einer weiteren mobilen Vorrichtung, mit der insbesondere eine Geräuschsituation erfasst wird. Bei der mobilen Vorrichtung handelt es sich hierbei um einen Tablett-Computer 200. Auf dem Display des Tablett-Computers 200 wird dabei der Grundriss eines Gebäudes 210 dargestellt. In diesem Grundriss sind die Fenster 220a, 220b durch längliche Rechtecke dargestellt. Zugeordnet zu den Fenstern zeigen Symbole 222a, 222b einen Geräuschpegel bei diesen Fenstern 220a, 220b dar. Bei dem dargestellten Geräuschpegel kann es sich um mit dem Tablett-Computer 200 gemessene Geräuschpegel oder um anhand von Karteninformationen, zum Beispiel einem Kartendienst wie Google Maps, geschätzten Geräuschpegel handeln. Der Benutzer bekommt somit einen schnellen Überblick über die Fenster und die Geräuschpegelsituation des Bauprojekts. Weiterhin kann der Benutzer über eine Eingabemaske 230 weitere Informationen, zum Beispiel Abmessungen, über die Fenster eingeben.

Der Tablett-Computer 200 stellt auf dem Display den Grundriss des Gebäudes dar, wie er zum Beispiel von einem Kartendienst wie Google Maps erhalten kann. Der Programmablauf kann dabei so sein, dass die mobile Vorrichtung über ein Satellitennavigationssystem wie GPS oder Galileo die aktuelle Position bestimmt und dann bestimmt, welches Gebäude dieser Position am nächsten kommt. Dieses Gebäude wird sodann dargestellt. In einem weiteren Schritt kann bestimmt werden, vor welcher Gebäudeseite 232, 234 die mobile Vorrichtung (und somit auch der Benutzer) sich befindet. Zum Beispiel kann, wenn der Benutzer zwischen der Straße und dem Gebäude steht, die vordere Gebäudeseite 232, zu der die mobile Vorrichtung gemäß bestimmter aktueller Position am nächsten ist, als die aktuelle Gebäudeseite identifiziert werden. Dies kann (in FIG. 5 nicht gezeigt) durch ein visuelles Hervorheben der vorderen Gebäudeseite angezeigt werden.

Für diese Gebäudeseite kann schließlich die Himmelsausrichtung aus dem Grundriss bestimmt werden, d.h. auf jeder Orientierung der Grundrisslinie der Gebäudeseite relativ zur Nordrichtung. Somit kann eine Bestimmung der Himmelsausrichtung von einen oder mehreren Gebäudeseiten auch eine Messung mit einem Kompass vorgenommen werden.

Vorteilhafterweise kann die Bestimmung der Himmelsausrichtung basierend auf einer Messung mit einem Kompass der mobilen Vorrichtung kombiniert werden mit einer Bestimmung der Himmelsausrichtung basierend auf dem Kartenservice, z.B. wie oben beschrieben. Zum Beispiel kann die Himmelsausrichtung als Durchschnitt der beiden getrennt aus Kompass und Kartenservice bestimmten Himmelsausrichtungen bestimmt werden. Alternativ kann, falls die Himmelsausrichtung aus Kompass und Kartenservice mehr als einen vorbestimmten Schwellenwert, z.B. 10°, voneinander abweichen, der Benutzer aufgefordert werden, die Messung mit dem Kompass zu wiederholen.

Weiterhin kann vorgesehen sein, dass das Verfahren weiterhin umfasst:

- Bestimmen einer lokalen Position der mobilen Vorrichtung mittels eines Positions-Sensors,
- Bestimmen einer Kompass-Himmelsausrichtung mittels eines Kompass,
- Bestimmen einer oder mehrere Karten-Himmelsausrichtungen einer oder mehrerer Wände eines Gebäudes nahe der lokalen Position, und
- Korrigieren der Kompass-Himmelsausrichtung basierend auf den ein oder mehreren Karten-Himmelsausrichtungen.

Somit kann die mobile Vorrichtung die lokale Position bestimmen und aus Informationen von einem Kartenservice (z. B. Google Maps) bestimmen, von welchem Gebäude gerade die Himmelsausrichtung von Wänden bestimmt wird. Somit kann die Kompassinformation anhand von Kartenservice-Informationen abgeglichen werden. Zum Beispiel kann, wenn der Kompass eine Ausrichtung von 10° anzeigt, in dem Kartenservice aber eine Ausrichtung einer nächstliegenden Wand des Gebäudes von 25° angegeben ist, eine Korrektur erfolgen. Insbesondere in Städten sind Kompass-Informationen oft ungenau, so dass die Information des Kartenservice vorgezogen werden kann. Zum Beispiel kann aus den Informationen des Kartenservice erkannt werden, dass das Gebäude sich in einem Stadtgebiet befindet und dann vorgesehen sein, dass die Kompass-Informationen anhand des Kartenservice korrigiert werden. Insbesondere kann der Benutzer gefragt werden, ob eine Korrektur vorgenommen werden soll, wenn eine Abweichung zwischen Kompass-Himmelsausrichtung und Karten-Himmelsausrichtungen erkannt wird.

Die mobilen Vorrichtung 100 und 200 können mit einer Datenbank oder mehreren Datenbanken ausgestattet oder verbunden sein. Beispielsweise kann das mobilen Endgerät mit einem Speichermedium ausgestattet sein, auf dem einer Datenbank hinterlegt ist. Alternativ oder zusätzlich können die mobilen Vorrichtungen dazu eingerichtet sein, mit einer Datenbank, beispielsweise einer Cloudspeicher-Datenbank, zu kommunizieren.

Die in der vorstehenden Beschreibung, den Figuren und den Ansprüchen offenbarten Merkmale können sowohl einzeln als auch in beliebiger Kombination für die Realisierung der Erfindung in den verschiedenen Ausgestaltungen von Bedeutung sein.

Bezugszeichen:

| | |
|---|---|
| 100, 200 | Mobile Vorrichtung |
| 105 | Benutzer |
| 102 | Vorderseite |
| 110, 210 | Bauprojekt |
| 120a, 120b, 120c, 220a, 220b | Fenster |
| 130 | Digitales Bild |
| 132 | Mikrofon |
| 134 | Pegelindikator |
| 200 | Tablett-Computer |
| 210 | Gebäude |
| 222a, 222b | Symbole |
| 230 | Eingabemaske |
| 232, 234 | Gebäudeseiten |

**Patentansprüche**

1.  Computer-implementiertes Verfahren zum Auslegen einer Fensterkonstruktion an einem Bauprojekt (110, 210), umfassend:

    - Erfassen einer Himmelsrichtung zumindest einer Gebäudeseite (102, 232, 234) des Bauprojekts,
    - Erfassen von Fensterflächen (120a, 120b, 120c) der Fensterkonstruktion zugeordnet zu Gebäudeseiten des Bauprojekts, und
    - Berechnen von Auslegungsparametern der Fensterkonstruktion basierend auf den erfassten Daten und einer Datenbank von Fenstern, wobei die Berechnung der Auslegungsparameter umfasst, eine Lichtsituation des Bauprojekts zu optimieren, und
    - Erfassen eines Geräuschpegels im Innen- und/oder Außenraum des Bauprojekts, unter Verwendung eines Mikrophons (132) der mobilen Vorrichtung (100, 200), wobei das Berechnen der Auslegungsparameter umfasst, eine Geräuschsituation des Bauprojekts (110) zu optimieren.

2.  Verfahren nach Anspruch 1, wobei die Lichtsituation eine Zuordnung der Nettoglasflächen zu Himmelsrichtungen umfasst, wobei die Optimierung der Lichtsituation des Bauprojekts umfasst, eine Abweichung der Zuordnung der Nettoglasflächen zu einer vorgegebenen Ideal-Verteilung zu minimieren, wobei die vorgegebene Ideal-Verteilung insbesondere eine vorgegebene Ideal-Zuordnung von Nettoglasflächen zu Grund-Himmelsrichtungen umfasst.

3.  Verfahren nach Anspruch 1 oder 2, weiterhin umfassend:

    - Erfassen einer Gebäudeklasse des Bauprojekts aus einer vorgegebenen Liste von Gebäudeklassen, die umfasst: Einfamilienhaus, Doppelhaushälfte, Reiheneckhaus, Reihenmittelhaus, Mehrfamilienhaus mit weniger als 6 Wohneinheiten, und/oder Mehrfamilienhaus mit zumindest 6 Wohneinheiten, und/oder
    - Erfassen einer Bauperiode des Gebäudes,

    wobei das Verfahren vorzugsweise weiterhin umfasst, die Gebäudeklasse und/oder die Bauperiode basierend auf einem digitalen Bild des Bauprojekts zu bestimmen.

4.  Verfahren nach einem der vorherigen Ansprüche, wobei das Berechnen der Auslegungsparameter weiterhin umfasst, eine regionale Präferenzsituation zu optimieren, wobei insbesondere die Datenbank eine Zuordnung zwischen Fenstern und einer regionalen Präferenz umfasst.

5. Verfahren nach einem der vorherigen Ansprüche, wobei das Verfahren weiterhin umfasst:

   - Erfassen von geographischen Koordinaten des Bauprojekts, und
   - Bestimmen von klimatischen Parametern basierend auf den geographischen Koordinaten, wobei die klimatischen Parameter insbesondere über eine Zuordnung der geographischen Parameter zu einer von mehreren Klimazonen erfolgt,

   wobei das Berechnen der Auslegungsparameter unter Berücksichtigung der klimatischen Parameter erfolgt, wobei die klimatischen Parameter insbesondere eine Jahres-Temperaturverteilung und/oder eine Jahres-Sonneneinstrahlungsverteilung umfassen, und/oder wobei das Optimieren der Lichtsituation umfasst:

   - Berechnen von Nettoglasflächen zugeordnet zu Gebäudeseiten des Bauprojekts, und/oder
   - Berechnen eines Verhältnisses von Nettoglasfläche zu einer Grundfläche des Bauprojekts und/oder einer Geschossanzahl des Bauprojekts.

6. Verfahren nach einem der vorherigen Ansprüche, weiterhin umfassend:

   - Aufnehmen eines digitalen Bildes (130) einer Gebäudeseite des Bauprojekts, und
   - automatisches Identifizieren eines oder mehrerer Fenster in dem digitalen Bild, wobei vorzugsweise eine Schätzung der Glasfläche, insbesondere der Nettoglasfläche, des einen Fensters oder der mehreren Fenster erfolgt,

   wobei das Verfahren vorzugsweise weiterhin umfasst:

   - Ausgeben einer ersten Benutzeraufforderung, um einen Benutzer (105) aufzufordern, eine mobile Vorrichtung (100, 200) in eine horizontale Orientierung zu bringen, und/oder
   - Ausgeben einer zweiten Benutzeraufforderung, um den Benutzer aufzufordern, die mobile Vorrichtung (100, 200) in eine vertikale Orientierung zu bringen.

7. Verfahren nach einem der vorherigen Ansprüche,,
   wobei das Verfahren weiterhin umfasst:

   - Erfassen einer Audio-Aufnahme und Bestimmen des Geräuschpegels basierend auf der Audio-Aufnahme sowie Identifizieren einer Art eines mit der Audio-Aufnahme erfassten Geräuschs, wobei das Optimieren der Geräuschsituation des Bauprojekts abhängig von der Art des Geräuschs erfolgt, und/oder
   - Bestimmen einer Tageszeit und/oder eines Wochentags und Anpassen des Geräuschpegels basierend auf der Tageszeit und/oder dem Wochentag.

8. Verfahren nach Anspruch 7, wobei das Erfassen des Geräuschpegels anhand einer Geo-Datenbank über Lärmquellen, insbesondere anhand eines Karten-Diensts mit Informationen über einen Verlauf und/oder eine Verkehrsbelastung von Straßen, erfolgt.

9. Verfahren nach einem der Ansprüche 7 oder 8, wobei das Verfahren weiterhin umfasst:

   - Detektieren einer Mikrophon-Fehlersituation, insbesondere einer Situation eines durch eine Hand eines Benutzers (105) abgedecktes Mikrophons (132), und
   - Ausgeben eines Aufforderungssignals an einen Benutzer, um den Benutzer zur Korrektur der Mikrophon-Fehlersituation aufzufordern.

10. Verfahren nach einem der Ansprüche 7 bis 9, wobei das Verfahren weiterhin umfasst, eine Normierung des durch ein Mikrophon (132) der mobilen Vorrichtung aufgenommenen Geräuschs vorzunehmen, wobei die Normierung insbesondere durch eine Zuordnung von Typen von mobilen Vorrichtungen zu Geräusch-Sensitivitäten der mobilen Vorrichtungen erfolgt.

11. Verfahren nach einem der vorherigen Ansprüche, wobei das Verfahren weiterhin umfasst, eine optimale Lüftungsfrequenz zu bestimmen, insbesondere unter Berücksichtigung von einer oder mehreren der folgenden Informationen: geographische Koordinaten, Angaben zur Fläche, Räumen, Wunschtemperatur, Position der Fenster, übliche Lüftungsstellung und Anzahl der Bewohner.

12. Mobile Vorrichtung (100, 200) zum Auslegen einer Fensterkonstruktion an einem Bauprojekt (105), umfassend:

- eine Himmelsrichtung-Erfassungsschnittstelle zum Erfassen einer Himmelsrichtung zumindest einer Gebäudeseite (102, 232, 234) des Bauprojekts (105),
- eine Fensterflächen-Erfassungsschnittstelle von Fensterflächen der Fensterkonstruktion zugeordnet zu Gebäudeseiten des Bauprojekts,
- eine Berechnungs-Einheit zum Berechnen von Auslegungsparametern der Fensterkonstruktion basierend auf den erfassten Daten und einer Datenbank von Fenstern, wobei die Berechnung der Auslegungsparameter umfasst, eine Lichtsituation des Bauprojekts zu optimieren, und
- eine Geräusch-Erfassungseinheit zum Erfassen eines Geräuschpegels im Innen- und/oder Außenraum des Bauprojekts, unter Verwendung eines Mikrophons der mobilen Vorrichtung, wobei das Berechnen der Auslegungsparameter umfasst, eine Geräuschsituation des Bauprojekts zu optimieren.

13. Mobile Vorrichtung (100, 200) nach Anspruch 12, wobei die Himmelsrichtung-Erfassungsschnittstelle einen Kompass umfasst, die Fensterflächen-Erfassungsschnittstelle eine Digitalkamera umfasst, und/oder die Vorrichtung weiterhin ein Mikrophon (132) zum Erfassen eines Geräuschpegels im Innen- und/oder Außenraum des Bauprojekts umfasst.

14. System, umfassend eine mobile Vorrichtung nach einem der Ansprüche 12 oder 13, und einen Server,

wobei die mobile Vorrichtung dazu ausgebildet ist, erfasste Informationen und/oder Benutzungsparameter an den Server zu übertragen und
wobei der Server dazu ausgebildet ist, eine Priorisierung von Bauprojekten basierend auf den erfassten Informationen und/oder Benutzungsparametern durchzuführen, und die Priorisierung insbesondere an eine mobile Ziel-Vorrichtung zu übertragen.

15. Computerprogramm mit Befehlen, die, wenn das Programm von einem Prozessor ausgeführt wird, den Prozessor veranlassen, das Verfahren nach einem der Ansprüche 1 bis 11 auszuführen.

**Claims**

1. A computer-implemented method for laying out a window structure on a construction project (110, 210), comprising:

- capturing of a compass direction of at least one building side (102, 232, 234) of the construction project,
- capturing of window areas (120a, 120b, 120c) of the window structure assigned to building sides of the construction project, and
- calculating design parameters of the window structure based on the collected data and a database of windows, wherein calculating the design parameters includes optimizing a lighting situation of the construction project and
- detecting a noise level in the interior and/or exterior of the construction project, using a microphone (132) of the mobile device (100, 200), wherein calculating the design parameters comprises optimizing a noise situation of the construction project (110).

2. The method of claim 1, wherein the lighting situation comprises an assignment of the net glass areas to cardinal directions, wherein optimizing the lighting situation of the construction project comprises minimizing a deviation of the assignment of the net glass areas to a predetermined ideal distribution, wherein the predetermined ideal distribution comprises in particular a predetermined ideal assignment of net glass areas to basic cardinal directions.

3. The method according to claim 1 or 2, further comprising:

- capturing a building class of the construction project from a predetermined list of building classes that includes: single-family house, semidetached house, terraced end house, terraced middle house, multi-family house with less than 6 dwelling units, and/or multi-family house with at least 6 dwelling units, and/or
- capturing a construction period of the building,

wherein the method preferably further comprises determining the building class and/or the construction period based on a digital image of the construction project.

**4.** The method according to one of the preceding claims, wherein calculating the design parameters further comprises optimizing a regional preference situation, in particular wherein the database comprises a mapping between windows and a regional preference.

**5.** The method according to one of the preceding claims, wherein the method further comprises:

- capturing of geographic coordinates of the construction project, and
- determining climatic parameters based on the geographic coordinates, wherein the climatic parameters are determined in particular by assigning the geographic parameters to one of several climatic zones,

wherein the calculation of the design parameters is performed taking into account the climatic parameters, wherein the climatic parameters comprise in particular an annual temperature distribution and/or an annual solar radiation distribution and/or wherein optimizing the lighting situation comprises:

- calculating net glass areas associated with building sides of the construction project, and/or
- calculating a ratio of net glass area to a floor area of the construction project and/or a number of stories of the construction project.

**6.** The method according to one of the preceding claims, further comprising:

- taking a digital image (130) of a building side of the construction project, and
- automatically identifying one or more windows in the digital image, preferably estimating the glass area, in particular the net glass area, of the one or more windows,

wherein the method further comprises:

- outputting a first user prompt to prompt a user (105) to bring a mobile device (100, 200) into a horizontal orientation, and/or
- outputting a second user prompt to prompt the user to move the mobile device (100, 200) to a vertical orientation.

**7.** The method according to one of the preceding claims, wherein the method further comprises:

- capturing an audio recording and determining the noise level based on the audio recording and identifying a type of a noise captured with the audio recording, wherein optimizing the noise situation of the construction project is performed depending on the type of the noise, and/or
- determining a time of day and/or day of week and adjusting the sound level based on the time of day and/or day of week.

**8.** The method according to claim 7, wherein the detection of the noise level is performed using a geo-database on noise sources, in particular using a map service with information on a course and/or a traffic load of roads.

**9.** The method of one of claims 7 or 8, wherein the method further comprises:

- detecting a microphone fault situation, in particular a situation of a microphone (132) covered by a hand of a user (105), and
- outputting a prompt signal to a user to prompt the user to correct the microphone error situation.

**10.** The method according to one of claims 7 to 9, the method further comprising normalizing the noise picked up by a microphone (132) of the mobile device, wherein the normalization is performed in particular by assigning types of mobile devices to noise sensitivities of the mobile devices.

**11.** The method according to one of the preceding claims, the method further comprising determining an optimal ventilation frequency, in particular taking into account one or more of the following information: geographical coordinates, area data, rooms, desired temperature, position of windows, usual ventilation position and number of occupants.

**12.** A mobile device (100, 200) for laying out a window structure on a construction project (105), comprising:

- a compass direction detection interface for detecting a compass direction of at least one building side (102, 232, 234) of the construction project (105),
- a window area capture interface of window areas of the window structure assigned to building sides of the construction project, and
- a calculation interface for calculating design parameters of the window structure based on the collected data and a database of windows, wherein calculating the design parameters includes optimizing a lighting situation of the construction project, and
- a noise detection interface for detecting a noise level in the interior and/or exterior of the construction project, using a microphone of the mobile device, wherein calculating the design parameters comprises optimizing a noise situation of the construction project.

13. The mobile device (100, 200) according to claim 12, wherein the compass direction detection interface comprises a compass, the window area detection interface comprises a digital camera, and/or the device further comprises a microphone (132) for detecting a noise level in the interior and/or exterior of the construction project.

14. A system comprising a mobile device according to one of claims 12 and 13, and a server,

wherein the mobile device is configured to transmit captured information and/or usage parameters to a server, and

wherein the server is configured to perform a prioritization of construction projects based on the captured information and/or usage parameters.

15. A computer program comprising instructions which, when the program is executed by a processor, causes the processor to perform the method of one of claims 1 to 11.

## Revendications

1. Procédé mis en œuvre de façon informatisée pour concevoir une construction de fenêtres sur un projet de construction (110, 210), comprenant :

   - saisie d'un point cardinal au moins d'un côté de bâtiment (102, 232, 234) du projet de construction,
   - saisie des surfaces de fenêtre (120a, 120b, 120c) de la construction de fenêtres attribuée aux côtés de bâtiment du projet de construction, et
   - calcul de paramètres de conception de la construction de fenêtres en se basant sur les données saisies et une banque de données de fenêtres, sachant que le calcul des paramètres de conception comprend une situation de lumière du projet de construction à optimiser, et
   - saisie d'un niveau de bruit dans l'espace intérieur et/ou extérieur du projet de construction en utilisant un microphone (132) du dispositif mobile (100, 200), sachant que le calcul des paramètres de conception comprend une situation de bruit du projet de construction (110) à optimiser.

2. Procédé selon la revendication 1, sachant que la situation de lumière comprend une attribution des surfaces vitrées nettes aux points cardinaux, sachant que l'optimisation de la situation de lumière du projet de construction comprend un écart de l'attribution des surfaces vitrées nettes à optimiser par rapport à une répartition idéale prédéfinie, sachant que la répartition idéale prédéfinie comprend en particulier une attribution idéale prédéfinie de surfaces vitrées nettes à des points cardinaux de base.

3. Procédé selon la revendication 1 ou 2, comprenant en plus :

   - saisie d'une catégorie de bâtiment du projet de construction à partir d'une liste prédéfinie de catégories de bâtiments, qui comprend : maison unifamiliale, moitié de maison jumelée, maison d'angle en rangée, maison centrale en rangée, immeuble collectif avec moins de 6 unités d'habitation et/ou immeuble collectif avec au moins 6 unités d'habitation, et/ou
   - saisie d'une période de construction du bâtiment,

   sachant que le procédé comprend de préférence en plus, la catégorie de bâtiment et/ou la période de construction à déterminer en se basant sur une image numérique du projet de construction.

4. Procédé selon l'une quelconque des revendications précédentes, sachant que le calcul des paramètres de conception comprend en plus une situation de préférence régionale à optimiser, sachant en particulier que la banque de données comprend une attribution entre les fenêtres et une préférence régionale.

5. Procédé selon l'une quelconque des revendications précédentes, sachant que le procédé comprend en plus :

- saisie de coordonnées géographiques du projet de construction, et
- détermination des paramètres climatiques en se basant sur les coordonnées géographiques, sachant que les paramètres climatiques ont lieu en particulier par une attribution des paramètres géographiques par rapport à une des nombreuses zones climatiques,

sachant que le calcul des paramètres de conception a lieu en tenant compte des paramètres climatiques, sachant que les paramètres climatiques comprennent en particulier une répartition de températures annuelle et/ou une répartition de l'ensoleillement annuel et/ou sachant que l'optimisation de la situation de lumière comprend :

- calcul des surfaces vitrées nettes attribué aux côtés de bâtiment du projet de construction, et/ou
- calcul d'un rapport entre la surface vitrée nette et une surface de base du projet de construction, et/ou un nombre d'étages du projet de construction.

6. Procédé selon l'une quelconque des revendications précédentes, comprenant en plus :

- enregistrement d'une image numérique (130) d'un côté de bâtiment du projet de construction, et
- identification automatique d'une ou de plusieurs fenêtres dans l'image numérique, sachant de préférence qu'une estimation de la surface vitrée, en particulier de la surface vitrée nette, d'une fenêtre ou de plusieurs fenêtres, a lieu,

sachant que le procédé comprend de préférence en plus :

- émission d'une première requête d'utilisateur pour inviter un utilisateur (105) à placer dans une orientation horizontale un dispositif mobile (100, 200), et/ou
- émission d'une deuxième requête d'utilisateur pour inviter l'utilisateur à placer dans une orientation verticale le dispositif mobile (100, 200).

7. Procédé selon l'une quelconque des revendications précédentes, sachant que le procédé comprend en plus :

- saisie d'un enregistrement audio et détermination du niveau de bruit en se basant sur l'enregistrement audio ainsi qu'identification d'un type d'un bruit saisi avec l'enregistrement audio, sachant que l'optimisation de la situation de bruit du projet de construction a lieu en fonction du type de bruit, et/ou
- détermination d'une période du jour et/ou d'un jour de semaine et adaptation du niveau de bruit en se basant sur la période de jour et/ou le jour de semaine.

8. Procédé selon la revendication 7, sachant que la saisie du niveau de bruit a lieu à l'aide d'une banque de données géographiques sur les sources sonores, en particulier à l'aide d'un service de cartes avec des informations concernant un profil et/ou une charge de trafic des rues.

9. Procédé selon l'une quelconque des revendications 7 ou 8, sachant que le procédé comprend en plus :

- détection d'une situation défectueuse de mircrophone, en particulier d'une situation d'un microphone (132) couvert par une main d'un utilisateur (105), et
- émission d'un signal de requête à un utilisateur pour inviter l'utilisateur à corriger la situation défectueuse de microphone.

10. Procédé selon l'une quelconque des revendications 7 à 9, sachant que le procédé comprend en plus une normalisation du bruit enregistré par un microphone (132) du dispositif mobile à pratiquer, sachant que la normalisation a lieu en particulier par une attribution de types de dispositifs mobiles aux sensibilités au bruit des dispositifs mobiles.

11. Procédé selon l'une quelconque des revendications précédentes, sachant que le procédé comprend en plus une fréquence d'aération optimale à déterminer, en particulier en tenant compte d'une ou de plusieurs des informations suivantes :

coordonnées géographiques, indications de surface, espaces, température souhaitée, position des fenêtres, position d'aération usuelle et nombre d'occupants.

12. Dispositif mobile (100, 200) pour concevoir une construction de fenêtres sur un projet de construction (105), comprenant :

- une interface de saisie de points cardinaux pour saisir un point cardinal au moins d'un côté de bâtiment (102, 232, 234) du projet de construction (105) ,
- une interface de saisie de surfaces de fenêtres des surfaces de fenêtres de la construction de fenêtres attribuée aux côtés de bâtiment du projet de construction,
- une unité de calcul pour calculer des paramètres de conception de la construction de fenêtres en se basant sur les données saisies et une banque de données de fenêtres, sachant que le calcul des paramètres de conception comprend une situation de lumière du projet de construction à optimiser, et
- une unité de saisie du bruit pour saisir un niveau de bruit dans l'espace intérieur et/ou extérieur du projet de construction en utilisant un microphone du dispositif mobile, sachant que le calcul des paramètres de conception comprend une situation de bruit du projet de construction à optimiser.

13. Dispositif mobile (100, 200) selon la revendication 12, sachant que l'interface de saisie de point cardinal comprend une boussole, l'interface de saisie de surfaces de fenêtre comprend une caméra numérique et/ou le dispositif comprend en plus un microphone (132) pour saisir un niveau de bruit dans l'espace intérieur et/ou extérieur du projet de construction.

14. Système, comprenant un dispositif mobile selon l'une quelconque des revendications 12 ou 13, et un serveur,

sachant que le dispositif mobile est constitué pour transmettre les informations et/ou les paramètres d'utilisation saisis et
sachant que le serveur est constitué pour effectuer une priorisation des projets de construction en se basant sur les informations et/ou paramètres d'utilisation saisis et transmettre la priorisation en particulier à un dispositif cible mobile.

15. Programme informatique avec des ordres, qui, lorsque le programme est effectué par un processeur, incitent le processeur à exécuter le programme selon l'une quelconque des revendications 1 à 11.

# FIG. 1

# FIG. 2

# FIG. 3

**FIG. 4a**

**FIG. 4b**

**FIG. 4c**

# FIG. 5

**EP 3 905 152 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140214473 A1

- US 2019180140 A1